# EUROPÄISCHE PATENTANMELDUNG

(11) **EP 1 118 874 A2**
(43) Veröffentlichungstag der Anmeldung: **25.07.2001**
(21) Anmeldenummer: 00127444.8
(22) Anmeldetag: 14.12.2000
(51) Int. Cl.: G01S 7/481, G01S 17/02, G01S 17/42

(54) **Optische Abtastvorrichtung**

(30) Priorität: 19.01.2000 DE 10002090
(71) Anmelder: SICK AG, 79183 Waldkirch (DE)
(72) Erfinder: Pierenkemper, Hans-Werner, 79312 Emmendingen (DE)
(74) Vertreter: Manitz, Finsterwald & Partner Gbr

(57) **Zusammenfassung**

Die Erfindung betrifft eine optische Abtastvorrichtung mit einem Lichtsender und einem Lichtempfänger, die in räumlicher Nähe zueinander angeordnet sind und jeweils eine Ablenkeinrichtung umfassen, mit denen ein von einer Sendeeinheit ausgesandter Abtastlichtstrahl entlang eines Sendekanals auf ein abzutastendes Objekt und nach Reflexion an dem Objekt entlang eines Empfangskanals auf eine Empfangseinheit lenkbar ist, wobei der Sendekanal und der Empfangskanal im Bereich des Lichtsenders und Lichtempfängers optisch voneinander getrennt sind.

## Beschreibung

Die Erfindung betrifft eine optische Abtastvorrichtung mit einem Lichtsender und einem Lichtempfänger, die in räumlicher Nähe zueinander angeordnet sind und jeweils eine Ablenkeinrichtung umfassen, mit denen ein von einer Sendeeinheit ausgesandter Abtastlichtstrahl entlang eines Sendekanals auf ein abzutastendes Objekt und nach Reflexion an dem Objekt entlang eines Empfangskanals auf eine Empfangseinheit lenkbar ist.

Derartige Abtastvorrichtungen dienen beispielsweise als nach dem Lichtlaufzeitprinzip arbeitende Entfernungsmeßgeräte, bei denen die Sendeeinheit eine Lasereinrichtung umfaßt.

Diese Systeme zeichnen sich durch eine hohe Empfindlichkeit des Lichtempfängers aus, die im Bereich von einigen nW liegen kann, so daß ein sicherer Nachweis auch von Objekten mit geringen Remissionsgraden gewährleistet ist. Die Sendeleistung des Lichtsenders dagegen ist um mehrere Größenordnungen höher und liegt beispielsweise im Bereich von einigen mW bis zu einigen W.

Problematisch bei derartigen Systemen ist, daß insbesondere aufgrund der im Vergleich zur Sendeleistung hohen Empfindlichkeit des Lichtempfängers Maßnahmen erforderlich sind, um eine Eigenblendung des Systems zu vermeiden, d.h. um zu verhindern, daß vom Lichtsender ausgesandtes Licht, das nicht vom abzutastenden Objekt, sondern von anderen Gegenständen reflektiert wird, von der Empfangseinheit nachgewiesen wird. Als Quellen eines derartigen störenden Streulichts sind z.B. die für den Lichtdurchtritt vorgesehenen Frontscheiben bekannt, die insbesondere in einem verschmutzten Zustand zu einer nachteiligen Aufstreuung des Sendelichts führen. Problematisch ist insbesondere, daß Eigenblendungen des Systems zu Sättigungseffekten der Empfangselektronik führen können, die eine Messung der Lichtlaufzeit mit hoher zeitlicher Auflösung unmöglich machen.

Aufgabe der Erfindung ist es, eine optische Abtastvorrichtung der eingangs genannten Art zu schaffen, bei der eine Eigenblendung sicher vermieden wird und die gleichzeitig einen möglichst einfachen Aufbau aufweist.

Die Lösung dieser Aufgabe erfolgt ausgehend von einer optischen Abtastvorrichtung der eingangs genannten Art erfindungsgemäß dadurch, daß der Sendekanal und der Empfangskanal im Bereich des Lichtsenders und Lichtempfängers optisch voneinander getrennt sind.

Durch die optische Trennung zwischen Sendekanal und Empfangskanal im Bereich des Lichtsenders und Lichtempfängers ist ausgeschlossen, daß Streulicht aus dem Sendekanal in den Empfangskanal gelangen und zu einer Blendung der Empfangseinheit führen kann. Ein Übersprechen zwischen Sendekanal und Empfangskanal kann erfindungsgemäß somit vollständig vermieden werden.

In einer bevorzugten Ausführungsform der Erfindung sind der Lichtsender und der Lichtempfänger in einem gemeinsamen Gehäuse angeordnet, wobei der Sendekanal und der Empfangskanal innerhalb des Gehäuses optisch voneinander getrennt sind. Bevorzugt erfolgt die Trennung dadurch, daß der Lichtsender und der Lichtempfänger jeweils in einer Kammer des Gehäuses angeordnet sind, wobei die Sendekammer und die Empfangskammer durch eine Trennwand lichtdicht voneinander getrennt sind.

Die optische Trennung zwischen Sendekanal und Empfangskanal erfolgt hierdurch mit denkbar einfachen konstruktiven Mitteln. Die erfindungsgemäße Abtastvorrichtung kann dadurch besonders kostengünstig hergestellt werden.

Die Sendekammer und die Empfangskammer können durch ein Lichtdurchtrittsfenster verschlossen sein. Die Sendeeinheit und die Empfangseinheit können so vor äußeren Einflüssen geschützt werden, wobei durch die lichtdichte Trennung zwischen der Sendekammer und der Empfangskammer Streueffekte an den Lichtdurchtrittsfenstern unproblematisch sind.

In einer bevorzugten praktischen Ausführung der Erfindung ist sowohl der Sendeeinheit als auch der Empfangseinheit eine Ablenkeinrichtung in Form eines zu einer Drehbewegung antreibbaren Spiegelrades zugeordnet. Senderseitig können mit einem derartigen, auch als Polygon bezeichneten Spiegelrad eine periodische Abtastbewegung ausführende Abtastlichtstrahlen erzeugt werden. Insbesondere bei derartigen Scannersystemen, bei denen bisher eine hohe potentielle Eigenblendungsgefahr bestand, wird durch die erfindungsgemäße optische Trennung zwischen Sendekanal und Empfangskanal störendes Streulicht wirksam vermieden.

Bevorzugt ist es dabei, wenn die beiden Spiegelräder zu einer gemeinsamen Drehbewegung antreibbar sind und eine gemeinsame Antriebswelle aufweisen, die lichtdicht durch die Trennwand zwischen der Sendekammer und der Empfangskammer hindurchgeführt ist.

Hierbei können die beiden auf der gemeinsamen Antriebswelle angeordneten Spiegelräder als eine einzige Ablenkeinrichtung in Form eines geteilten Spiegelrades für das Gesamtsystem angesehen werden, bei der durch die Trennwand ein Sendeabschnitt und ein Empfangsabschnitt in optischer Hinsicht vollständig voneinander getrennt sind. Die Synchronisation der beiden Spiegelräder bzw. der beiden Abschnitte des gemeinsamen, geteilten Spiegelrades ist dabei durch die gemeinsame Drehbewegung gewährleistet, während das Eindringen von störendem Streulicht in den Empfangskanal vollständig ausgeschlossen ist.

Weitere bevorzugte Ausführungsformen der Erfindung sind auch in den Unteransprüchen, der Beschreibung sowie der Zeichnung angegeben.

Die Erfindung wird im folgenden beispielhaft unter Bezugnahme auf die Zeichnung beschrieben. Es zeigen:
- Fig. 1: eine optische Abtastvorrichtung gemäß einer Ausführungsform der Erfindung in einer geschnittenen Ansicht,
- Fig. 2a: die Abtastvorrichtung von Fig. 1 in einer geschnittenen, gegenüber Fig. 1 um 90° gedrehten Ansicht im Bereich eines Lichtsenders, und
- Fig. 2b: eine Ansicht entsprechend Fig. 2a im Bereich eines Lichtempfängers.

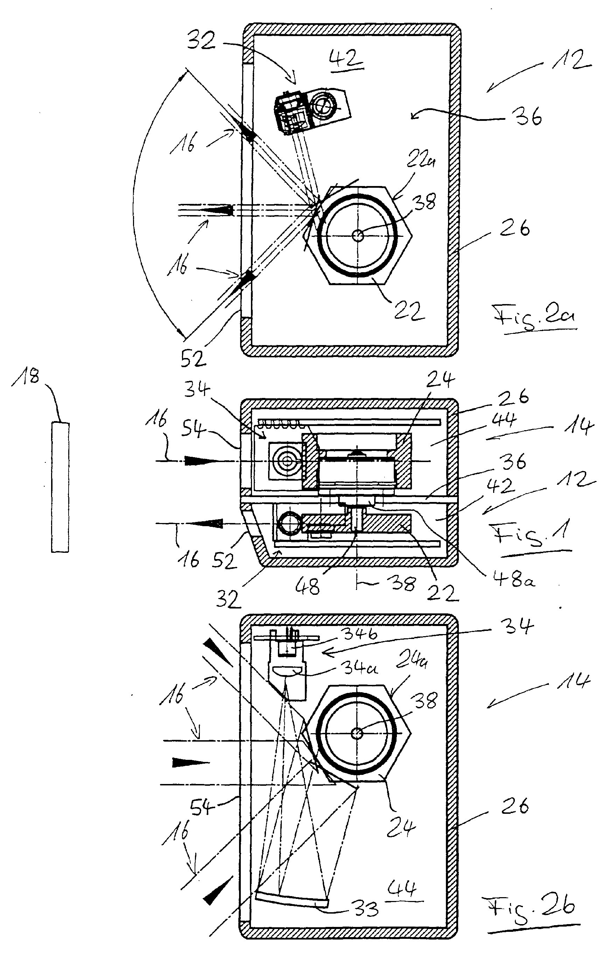

Die optische Abtastvorrichtung gemäß Fig. 1 umfaßt einen Lichtsender 12 und einen Lichtempfänger 14, die jeweils in einer Kammer 42, 44 eines gemeinsamen Gehäuses 26 in räumlicher Nähe zueinander angeordnet sind. Die Sendekammer 42 und die Empfangskammer 44 sind durch eine lichtundurchlässige Trennwand 36 voneinander getrennt. In der Gehäusewand ist für jede der Kammern 42, 44 ein beispielsweise aus Glas hergestelltes Lichtdurchtrittsfenster 52, 54 vorgesehen.

Zur Beschreibung des Lichtsenders 12 und des Lichtempfängers 14 wird auch auf die bezüglich Fig. 1 jeweils um 90° gedrehten Ansichten der Fig. 2a und 2b Bezug genommen.

Der Lichtsender 12 umfaßt eine Sendeeinheit 32 mit einer Laservorrichtung sowie eine Ablenkeinrichtung 22 in Form eines um eine Achse 38 drehbar antreibbaren Spiegelrades 22. Vom Laser der Sendeeinheit 32 ausgesandtes Licht trifft auf eine der ebenen Spiegelflächen 22a des sich im Betrieb drehenden Spiegelrades 22 und wird in Abhängigkeit von dessen momentaner Winkelstellung unter einem bestimmten, in diesem Ausführungsbeispiel in einem Winkelbereich von etwa 90° liegenden Winkel als Abtastlichtstrahl 16 durch das Fenster 52 abgestrahlt. Die Gesamtheit aller Lichtausbreitungswege für von der Sendeeinheit 32 stammende Abtastlichtstrahlen 16 bildet bis zur Reflexion an einem Objekt 18 (vgl. Fig. 1), dessen Entfernung gemessen werden soll, einen Sendekanal.

Der Lichtempfänger 14 umfaßt ein entsprechend dem Spiegelrad 22 des Lichtsenders 12 ausgebildetes Spiegelrad 24, eine Fokussiereinrichtung 33 in Form eines Hohlspiegels und eine Empfangseinheit 34 mit einer Linsenanordnung 34a und einem lichtempfindlichen Element 34b.

Die Gesamtheit aller Lichtausbreitungswege für von dem Objekt 18 reflektierte Abtastlichtstrahlen 16 bildet bis zum Nachweis an der Empfangseinheit 34 einen Sendekanal.

Die vom Objekt 18 reflektierten und sich entlang des Empfangskanals ausbreitenden Lichtstrahlen 16 treten über das Fenster 54 in die Empfangskammer 44 ein und werden von einer der lichtreflektierenden Flächen 24a des Spiegelrades 24 auf den Hohlspiegel 33 reflektiert und von diesem auf die Linsenanordnung 34a der Empfangseinheit 34 fokussiert.

Die Spiegelräder 22, 24 sind auf einer gemeinsamen Antriebswelle 48 angebracht und somit zu einer gemeinsamen Drehbewegung antreibbar. Dabei sind die Spiegelräder 22, 24 derart relativ zueinander ausgerichtet, daß die Spiegelflächen 22a und 24a nicht gegeneinander verdreht sind, sondern jeweils in derselben Ebene liegen.

Die beiden Ablenkeinrichtungen 22, 24 des Lichtsenders 12 und des Lichtempfängers 14 bilden somit ein einziges Spiegelrad, das durch die Trennwand 36 unterbrochen ist. Die Trennwand 36 erstreckt sich in den Zwischenraum des geteilten Spiegelrades 22, 24 hinein bis zu der gemeinsamen Antriebswelle 48 bzw. einer die Antriebswelle 48 umgebenden Abdeckung 48a derart, daß die Antriebswelle 48 lichtdicht durch die Trennwand 36 hindurchgeführt ist. Somit ist auch im Bereich des Durchtritts der Antriebswelle 48 sichergestellt, daß kein Streulicht aus der Sendekammer 42 in die Empfangskammer 44 gelangen kann.

Bei der erfindungsgemäßen optischen Abtastvorrichtung handelt es sich nicht um ein koaxiales System, sondern der Sendekanal und der Empfangskanal liegen nebeneinander und verlaufen zwischen dem Objekt 18 und der jeweiligen Ablenkeinrichtung 22, 24 näherungsweise parallel zueinander. Der Winkel zwischen Sendekanal und Empfangskanal, der von der Entfernung zwischen dem Gehäuse 26 und dem Objekt 18 sowie von dem Abstand zwischen dem Lichtsender 12 und dem Lichtempfänger 14 senkrecht zur Lichtausbreitungsrichtung abhängig ist, wird bei der Auswertung der von der Empfangseinheit 34 nachgewiesenen Signale berücksichtigt. Hinsichtlich der Energiebilanz des Systems ist dieser Winkel für den erfindungsgemäßen Scanner insbesondere deshalb unproblematisch, da dieser senkrechte Abstand zwischen Lichtsender 12 und Lichtempfänger 14 (geometrische Basis) um mehrere Größenordnungen kleiner als die Entfernung zwischen Gehäuse 26 und Objekt 18 (Arbeits- oder Abtastbereich des Scanners) ist.

Von den Spiegelrädern 22, 24 werden im Abtastbetrieb synchron die gleichen Winkelsegmente abgetastet. Eine Autokollimationsfunktion des Systems ist dennoch gegeben, wodurch eine Unterdrückung von Fremdlicht bzw. Hintergrundstrahlung erfolgt.

Durch die Trennwand 36 zwischen der den Lichtsender 12 enthaltenden Sendekammer 42 und der den Lichtempfänger 14 enthaltenden Empfangskammer 44 sind der Sendekanal und der Empfangskanal innerhalb des Gehäuses 26 in optischer Hinsicht vollständig voneinander getrennt, so daß ein Übersprechen zwischen dem Sendekanal und dem Empfangskanal sicher ausgeschlossen wird. Eine Eigenblendung des Systems tritt folglich auch bei verschmutzten Lichtdurchtrittsfenstern 52, 54 nicht auf.

Ein wesentlicher Vorteil der Erfindung besteht darin, daß der Empfänger 14 in keiner Weise vom Sender 12 beeinflußt wird und somit vollkommen unabhängig vom Sender 12 konstruiert werden kann, z.B. mit dem Ziel einer Linearisierung des Verlaufs der Empfangsamplitude über die Entfernung zum Objekt 18, d.h. über den Tastabstand des Scanners. Beim Design des Empfängers 14 kann man sich also auf optimale Empfangseigenschaften konzentrieren, ohne dabei eventuelle Störungen durch den Sender 12 berücksichtigen zu müssen.

Ein anderer wesentlicher Vorteil der Erfindung besteht in der konstruktiven Einfachheit der Anordnung und der Möglichkeit, kostengünstige Komponenten zu verwenden, die insbesondere keine speziellen optischen und elektrischen Abschirmungen aufweisen müssen. Ein weiterer Vorteil besteht darin, daß die Abtastvorrichtung mit einer vergleichsweise geringen Baugröße realisiert werden kann.

### Bezugszeichenliste

- 12: Lichtsender
- 14: Lichtempfänger
- 16: Abtastlichtstrahl
- 18: Objekt
- 22: Ablenkeinrichtung
- 22a: lichtreflektierende Fläche
- 24: Ablenkeinrichtung
- 24a: lichtreflektierende Fläche
- 26: Gehäuse
- 32: Sendeeinheit
- 33: Fokussiereinrichtung
- 34: Empfangseinheit
- 34a: Linsenanordnung
- 34b: lichtempfindliches Element
- 36: Trennwand
- 38: Drehachse
- 42: Sendekammer
- 44: Empfangskammer
- 48: Antriebswelle
- 48a: Abdeckung
- 52: Lichtdurchtrittsfenster
- 54: Lichtdurchtrittsfenster

## Patentansprüche

1. Optische Abtastvorrichtung, insbesondere nach dem Lichtlaufzeitprinzip arbeitender Laserentfernungsmesser, mit einem Lichtsender (12) und einem Lichtempfänger (14), die in räumlicher Nähe zueinander angeordnet sind und jeweils eine Ablenkeinrichtung (22, 24) umfassen, mit denen ein von einer Sendeeinheit (32) ausgesandter Abtastlichtstrahl (16) entlang eines Sendekanals auf ein abzutastendes Objekt (18) und nach Reflexion an dem Objekt (18) entlang eines Empfangskanals auf eine Empfangseinheit (34) lenkbar ist, wobei der Sendekanal und der Empfangskanal im Bereich des Lichtsenders (12) und Lichtempfängers (14) optisch voneinander getrennt sind.

2. Optische Abtastvorrichtung nach Anspruch 1,
dadurch **gekennzeichnet,**
daß der Lichtsender (12) und der Lichtempfänger (14) in einem gemeinsamen Gehäuse (26) angeordnet sind und der Sendekanal und der Empfangskanal innerhalb des Gehäuses (26) optisch voneinander getrennt sind.

3. Optische Abtastvorrichtung nach Anspruch 1 oder 2,
dadurch **gekennzeichnet,**
daß der Lichtsender (12) und der Lichtempfänger (14) jeweils in einer Kammer (42, 44) des Gehäuses (26) angeordnet sind, wobei die Sendekammer (42) und die Empfangskammer (44) insbesondere durch eine Trennwand (36) lichtdicht voneinander getrennt sind.

4. Optische Abtastvorrichtung nach Anspruch 3,
dadurch **gekennzeichnet,**
daß die Sendekammer (42) und/oder die Empfangskammer (44) durch ein insbesondere aus Glas hergestelltes Lichtdurchtrittsfenster (52, 54) verschlossen sind/ist.

5. Optische Abtastvorrichtung nach zumindest einem der vorhergehenden Ansprüche,
dadurch **gekennzeichnet,**
daß der Sendekanal und der Empfangskanal zumindest außerhalb eines Gehäuses (26) näherungsweise parallel zueinander verlaufen.

6. Optische Abtastvorrichtung nach zumindest einem der vorhergehenden Ansprüche,
dadurch **gekennzeichnet,**
daß zur Erzeugung eines eine periodische Abtastbewegung ausführenden Abtastlichtstrahls (16) zumindest die der Sendeeinheit (32) zugeordnete Ablenkeinrichtung (22) wenigstens eine vorzugsweise periodisch bewegbare lichtreflektierende Fläche (22a) aufweist.

7. Optische Abtastvorrichtung nach Anspruch 6,
dadurch **gekennzeichnet,**
daß die Ablenkeinrichtung (22) eine Mehrzahl von zumindest einen Teil eines Polyeders bildenden lichtreflektierenden Flächen (22a) umfaßt und insbesondere als zu einer Drehbewegung antreibbares Spiegelrad ausgebildet ist.

8. Optische Abtastvorrichtung nach zumindest einem der vorhergehenden Ansprüche,
dadurch **gekennzeichnet,**
daß die Empfangseinheit (34) eine Ablenkeinrichtung (32) mit den eine Ablenkeinrichtung betreffenden Merkmalen zumindest eines der Ansprüche 6 und 7 umfaßt, wobei bevorzugt im Empfangskanal zwischen der Ablenkeinrichtung (32) und der Empfangseinheit (34) eine Fokussiereinrichtung (33), vorzugsweise ein Hohlspiegel, zum Konzentrieren von von der Ablenkeinrichtung (32) reflektierten Lichtstrahlen (16) an der Empfangseinheit (34) angeordnet ist.

9. Optische Abtastvorrichtung nach zumindest einem der vorhergehenden Ansprüche,
dadurch **gekennzeichnet,**
daß die Ablenkeinrichtungen (22, 24) auf einer gemeinsamen Drehachse (38) angeordnet und bevorzugt zu einer gemeinsamen Drehbewegung antreibbar sind.

10. Optische Abtastvorrichtung nach zumindest einem der vorhergehenden Ansprüche,
dadurch **gekennzeichnet,**
daß eine gemeinsame Antriebswelle (48) der Ablenkeinrichtungen (22, 24) lichtdicht durch eine Trennwand (36) zwischen einer Sendekammer (42) und einer Empfangskammer (44) hindurchgeführt ist. -.-.-.
